# EUROPEAN PATENT SPECIFICATION

(11) **EP 1 667 292 B1**
(45) Date of publication and mention of the grant of the patent: **03.11.2010**
(21) Application number: 04786431.9
(22) Date of filing: 26.08.2004
(51) Int. Cl.: H01S 5/343, H01L 33/06, H01L 33/32

(54) **GaN III-V COMPOUND SEMICONDUCTOR LIGHT-EMITTING DEVICE AND METHOD FOR MANUFACTURING SAME**
LICHTEMITTIERENDES BAUELEMENT AUS GaN III-V VERBINDUNGSHALBLEITERMATERIAL UND ZUGEHÖRIGES HERSTELLUNGSVERFAHREN
DISPOSITIF ELECTROLUMINESCENT A SEMI-CONDUCTEUR A COMPOSE GaN III-V, ET SON PROCEDE DE FABRICATION

(30) Priority: 26.08.2003 JP 2003300738
(43) Date of publication of application: 07.06.2006
(73) Proprietor: Sony Corporation, Minato-ku Tokyo (JP)
(72) Inventor: TOMIYA, Shigetaka,, Tokyo (JP); GOTO, Osamu,, Shiroishi-shi, Miyagi 989-0734 (JP)
(74) Representative: Müller, Frithjof E.
(86) International application number: PCT/JP2004/012708
(87) International publication number: WO 2005/020396

(56) References cited:
- EP-A- 1 248 303
- JP-A- 5 063 290
- JP-A- 7 122 812
- JP-A- 9 139 543
- JP-A- 10 065 271
- JP-A- 11 074 564
- JP-A- 11 330 614
- JP-A- 2000 261 106
- JP-A- 2001 168 471
- JP-A- 2002 261 393

## Description

### TECHNICAL FIELD

The present invention relates to a GaN-based III-V group compound semiconductor light-emitting element and a method for manufacturing thereof, and particularly to the GaN-based III-V group compound semiconductor light-emitting element having a light-emitting wavelength of 440 nm or more, which has high light-emitting efficiency and high reliability and the method for manufacturing thereof.

### BACKGROUND ART

A GaN-based III-V group compound semiconductor is a direct transition semiconductor having a forbidden band ranging from 1.9 eV to 6.2 eV, in which a light emission can be obtained from a visible region to an ultraviolet region.

Attention has been paid to the GaN-based III-V group compound semiconductor having such a semiconductor characteristic as a material for a semiconductor light-emitting element such as a semiconductor laser diode (LD) or a light emitting diode (LED) of blue or green color, and recently the blue and green semiconductor light-emitting elements using the GaN-based III-V group compound semiconductor have been developed actively.

The blue and green LEDs have already been put into practical use, and with respect to the LD, the practical use of a blue-violet semiconductor LD, from which light having a light-emitting wavelength of approximately 400 nm can be obtained, to improve a recording density of an optical recording medium such as an optical disc, is close at hand.

In addition, a semiconductor laser element of a pure blue or green semiconductor having a light-emitting wavelength longer than 400 nm has been expected to be developed so as to be used as a light source of a laser display apparatus or to be applied to medical equipment.

In those GaN-based compound semiconductor light-emitting elements having a light-emitting wavelength of 400 nm to 460 nm, a GaInN layer is mainly used as a well layer of a quantum well structure constituting an active layer.

In order to make a wavelength longer than that of the blue-violet color, In composition of the GaInN layer constituting the well layer needs to be increased; however, a crystallinity of the GaInN layer deteriorates due to the increase in the In composition, and as a result, a light-emitting efficiency of the GaN-based compound semiconductor light-emitting element deteriorates.

Since an injection current density is low in an LED, there may be a case in which the deterioration of the crystallinity is not particularly a problem when an LED having a longer wavelength than that of the blue-violet color is put into a practical use; however in the case of a semiconductor laser element having a high injection current density, there arises such problems that due to the deterioration of the crystallinity the light-emitting efficiency of a semiconductor laser element decreases, a threshold value becomes high and reliability deteriorates.

Therefore, in order to enhance the development of the semiconductor laser element of the pure blue or green semiconductor having a light-emitting wavelength longer than 400 nm, it has been desired to improve the crystallinity of the GaInN layer when the In composition is made to increase.

JP-A-2001/168 471 deals with the problem of how to lower a threshold voltage or drive voltage of a nitride semiconductor light-emitting element. To solve this problem an intermediate layer of AlGaN with a band gap energy larger than that of the barrier layer is formed over a well layer.

EP-A-1 248 303 deals with the problem of how to enhance the emission output of a light-emitting device including an active layer made of a nitride semiconductor containing indium. To solve this problem a first barrier layer made of AlGaN is formed on a well layer.

The following structure has been proposed in Japanese Published Patent Application No. 2000-349398, for example, in order to provide a nitride semiconductor light-emitting element having a high output power and high element reliability. Specifically, the nitride semiconductor light-emitting element proposed in the above described Patent Gazette is a nitride semiconductor light-emitting element including: an n-type cladding layer formed of an n-type nitride semiconductor, an active layer formed of a multiple quantum well structure having a well layer made of Ga_{1-c}In_{c}N (0 ≤ c < 1) and a p-type cladding layer formed of a p-type nitride semiconductor, in which a first p-type nitride semiconductor layer made of AlₐGa₁₋ₐN (0 < a < 1), having a larger energy gap than the p-type cladding layer and a second p-type nitride semiconductor layer made of Al_{b}Ga_{1-b}N (0 < b < 1) are provided between the active layer and the p-type cladding layer.
[Patent Reference 1] Japanese Published Patent Application No. 2000-349398 (page 5, FIG. 1)

### DISCLOSURE OF THE INVENTION

However, the structure disclosed in the above-described Gazette is intended to apply to a blue semiconductor laser element, and when only the above-described structure is provided, it is not considered to have sufficient effectiveness in the GaN-based III-V group compound semiconductor laser element having a wavelength longer than 400 nm.

As is understood from the explanation above, although it is desired to obtain the pure blue or green GaN-based III-V group compound semiconductor laser element which has a light-emitting wavelength longer than 400 nm, it has been difficult in related art to obtain a light-emitting wavelength longer than 400 nm, even when an attempt is made by increasing the In composition of the GaInN layer constituting the active layer, due to the fact that the crystallinity of the GaInN layer deteriorates, the quality of the active layer deteriorates, and the reliability of the semiconductor laser element becomes lowered.

Accordingly, the present invention aims to provide a GaN-based III-V group compound semiconductor light-emitting element having a light-emitting wavelength of 440 nm or more and having high light-emitting efficiency and reliability, and to provide a method for manufacturing thereof.

Inventors of the present invention and others have analyzed as follows the cause of deterioration in crystallinity of a GaInN layer when In composition is increased.

The deterioration of the crystallinity of the GaInN layer is mainly caused by the generation of a crystal defect, the reason for which is classified into two kinds. One of the reasons is a linear crystal defect (dislocation) extending from an active layer in the direction of crystal growth, which is caused mainly by a lattice mismatch between a well layer and a barrier layer, and the other reason is a planar crystal defect generated in the surface of an active layer, which is caused by excessive In-In bonding.

The planar crystal defect is crystal defects generated in a planar form, such as an anti-phase boundary defect and a laminated layer defect. Since the planar crystal defect may become a main cause of not emitting light, optical output efficiency to an injected current decreases when the planar crystal defect exists.

Therefore, the following experiments were conducted in order to develop a countermeasure for restraining the generation of the planar crystal defect.

### Experiment 1

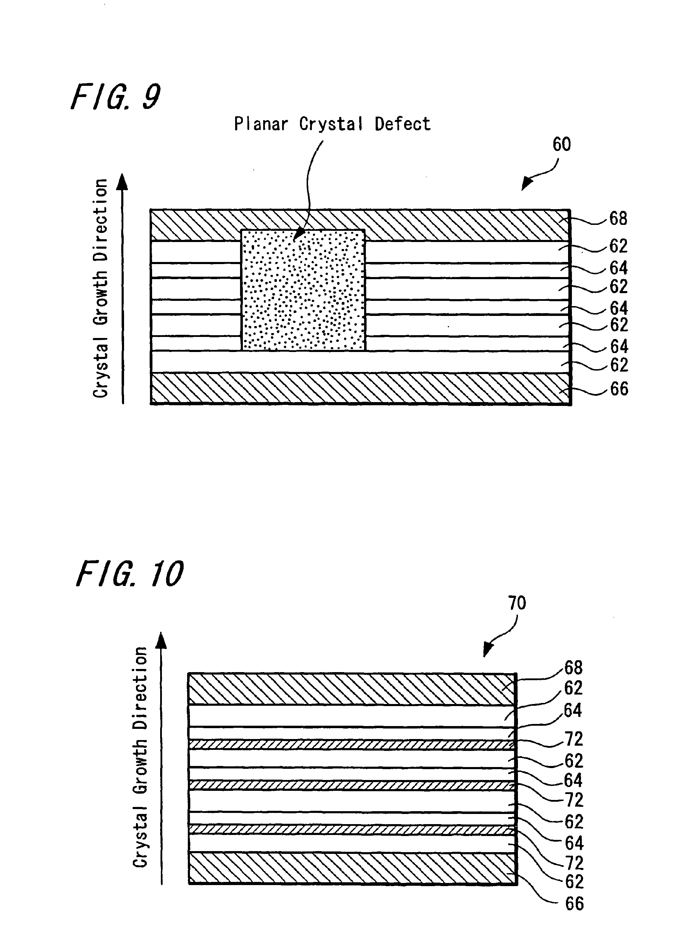

The inventors of the present invention have formed, as shown in FIG. 9, a triple quantum well structure 60 including barrier layers 62 made of Ga₁₋ₓInₓN (x = 0.03) layers having a film thickness of 5 nm and well layers 64 made of Ga_{1-z}In_{z}N (z = 0.14) layers having a thickness of approximately 2.5 nm and have studied a status of generation of a crystal defect to find that the planar crystal defect has been generated in an interface between the barrier layer 62 and the well layer 64. In addition, in-plain density of the crystal defect was 10⁹/cm² level or more. Reference numerals 66 and 68 in FIG. 9 respectively denote an n-side optical guide layer and a p-side optical guide layer. Hereupon, FIG. 9 is a cross-sectional view showing the structure of an active layer of a sample in the experiment 1.

When a GaN layer was used as the barrier layer 62, the result was the same as that of the Ga₁₋ₓInₓN (x = 0.03) layer.

### Experiment 2

The inventors of the present invention have realized that a mechanism to restrain the generation of the planar crystal defect between the upper surface of the barrier layer 62 and the lower surface of the well layer 64 has been required.

Therefore, the inventors have formed, as shown in FIG. 10, a triple quantum well structure 70 in which an Al_{y}Ga_{1-y}N (y = 0.02) layer 72 having a thickness of approximately 1 nm containing Al and not containing In was provided as a planar crystal defect prevention layer between the same upper surface of the barrier layer 62 and lower surface of the well layer 64 as those in the experiment 1. In other words, a sample of the experiment 2 was the same as that of the experiment 1 except that the Al_{y}Ga_{1-y}N (y = 0.02) layer 72 having the thickness of approximately 1 nm was provided between the upper surface of the barrier layer 62 and the lower surface of the well layer 64. Hereupon, FIG. 10 is a cross-sectional view showing the structure of an active layer of the sample in the experiment 2.

When a status of generation of a crystal defect was studied, it was recognized that the density of generating the planar crystal defect was restrained by one to two digits or more. When the planar crystal defect was generated, there might occur an excessive strain field in a surrounding area thereof and therefore, there has been a case in which a linear crystal defect such as a dislocation was caused by the planar crystal defect. However, the generation of those linear crystal defects has also not been observed.

When a GaN layer was used as the barrier layer, also the result was the same as that of the Ga₁₋ₓInₓN (x = 0.03) layer.

### Experiment 3

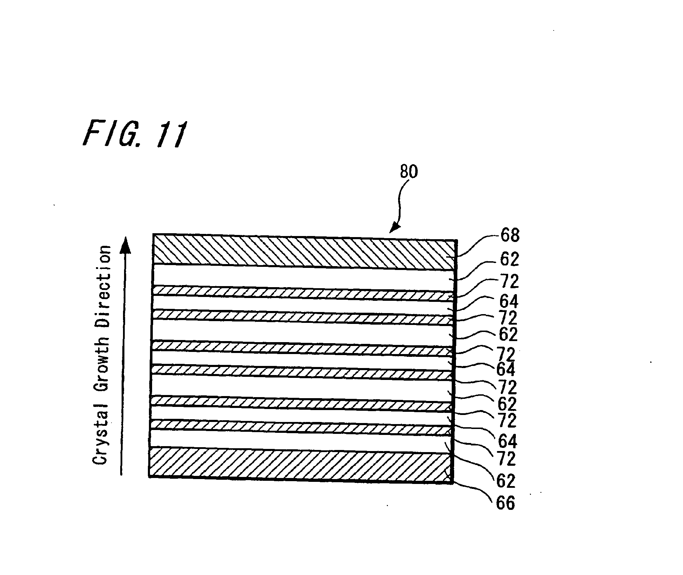

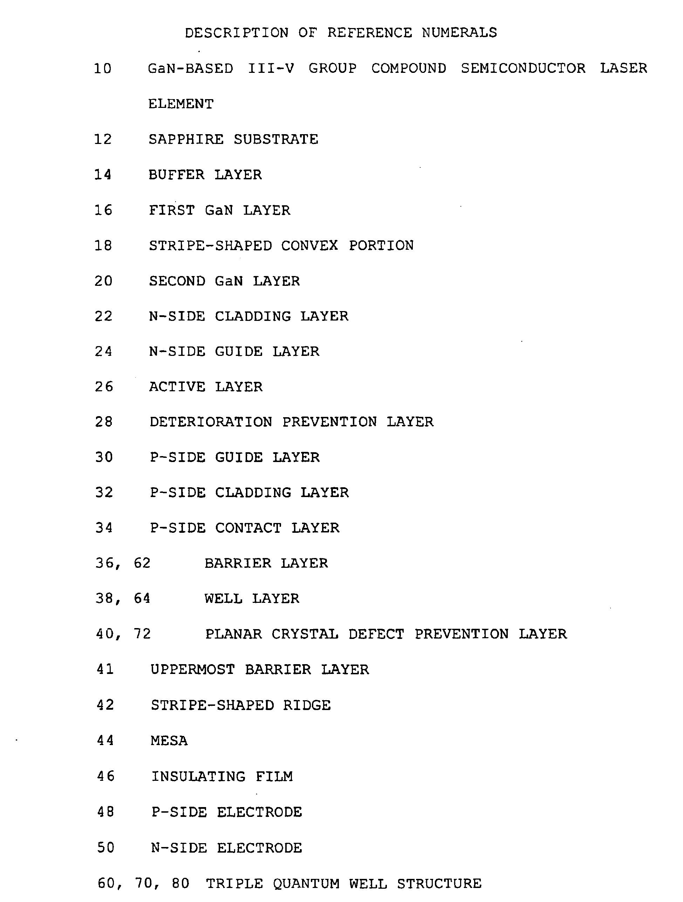

Further, the inventors have formed, as shown in FIG. 11, a triple quantum well structure 80 in which an Al_{y}Ga_{1-y}N (y = 0.02) layer having a thickness of approximately 1 nm containing Al and not containing In was provided as a planar crystal defect prevention layer 72 between the upper surface of the barrier layer 62 and lower surface of the well layer 64 similarly to the experiment 1, as well as between the upper surface of the well layer 64 and the lower surface of the barrier layer 62. Specifically, the sample of the experiment 3 was the same as that of the experiment 1 except that the Al_{y}Ga_{1-y}N (y = 0.02) layer 72 having a thickness of approximately 1 nm was provided between the upper and lower surfaces of the barrier layer 62 and the well layer 64. FIG. 11 is a sectional view showing an active layer structure of a sample of the experiment 3.

When a status of generation of a crystal defect was studied, it was recognized that the density of generating the planar crystal defect was further restrained.

When a GaN layer was used as the barrier layer, the result was the same as that of the Ga₁₋ₓInₓN (x = 0.03) layer.

### Experiment 4

Further, the inventors have formed a triple quantum well structure 80, whose cross-section is shown in FIG. 11, similarly to the experiment 3 except that an Al_{z}Ga_{1-z}N (z = 0.02) was used as the barrier layer 62 and an Al_{y}Ga_{1-y}N (y = 0.025) layer having a thickness of approximately 0.5 nm was used as the planar crystal defect prevention layer 72. When a status of generation of a crystal defect was studied, it was recognized that the generation of the planar crystal defect was restrained.

### Experiment 5

Further, the inventors have formed a triple quantum well structure 80, whose cross-section is shown in FIG. 11, similarly to the experiment 3 except that an Al_{z}Ga_{1-z}N (z = 0.02) layer was used as the barrier layer 62 and an Al_{y1}In_{y2}Ga_{1-y1-y2}N layer 72 having a thickness of approximately 0.5 nm was used as the planar crystal defect prevention layer 72. Hereupon, the planar crystal defect prevention layer 72 is made to have a composition gradient structure distributed linearly from the same composition as the barrier layer 62 to the same composition as the well layer 64 (namely, 0.02 ≥ y1 ≥ 0, 0≤ y2 ≤ 0.14). When a status of generation of a crystal defect was studied, it was recognized that the density of generating the planar crystal defect was greatly restrained to be 10⁶/cm² or less.

In order to solve the above mentioned problems, based on the above knowledge, a GaN-based III-V group compound semiconductor light-emitting element according to the present invention is the GaN-based III-V group compound semiconductor light-emitting element of any of claims 1, 10 and 11.

In the present invention, the GaN-based III-V group compound semiconductor is a compound semiconductor which has nitrogen (N) as a V group and whose composition is shown as AlₐB_{b}Ga_{c}In_{d}NₓP_{y}As_{z} (a + b + c + d = 1, 0 ≤ a, b, d ≤ 1, 0 < c ≤ 1, x + y + z = 1, 0 < x ≤ 1, 0 ≤ y, z ≤ 1).

In the present invention, the upper surface of the barrier layer is a surface of the barrier layer on the side opposite to a substrate and the lower surface of the well layer is a surface of the well layer on the substrate side.

The present invention can be applied to any structure of an active layer as long as a GaN-based III-V group compound semiconductor light-emitting element having the active layer of the quantum well structure formed of the barrier layer made of the GaN-based compound semiconductor and the well layer made of the GaInN layer and having a light-emitting wavelength of 440 nm or more is employed. Moreover, the present invention is applicable irrespective of the shape of a ridge and a current constriction structure. Further, the present invention is applicable without considering the difference between a semiconductor laser element and a light-emitting diode.

According to an embodiment of the present invention, In composition of the GaInN layer constituting the well layer is 0.25 > In > 0, and the barrier layer is a GaInN (0.1 > In ≥ 0) layer, an AlGaN layer (0.2 > Al ≥ 0) or an AlInGaN layer (0.2 > Al ≥ 0, 0.1 > In ≥ 0).

A method for manufacturing a GaN-based III-V group compound semiconductor light-emitting element according to the present invention is the method for manufacturing the GaN-based III-V group compound semiconductor light-emitting element of claim 6.

According to the structure of the present invention, since the Alₓ₁Ga₁₋ₓ₁N layer (0.4 > x1> 0.02) or Al_{z1}In_{z2}Ga_{1-z1-z2}N layer (where Al composition z1 is 0.2 > z1 > 0 and In composition z2 is 0.1 > z2 >0) including Al and having the thickness of 3 nm or less is provided on the lower surface and the upper surface of the GaInN well layer, those layers function as the planar crystal defect prevention layer. Accordingly, the planar crystal defect generated on interfaces of the upper surface and lower surface of the GaInN well layer due to an increase of the In composition in the well layer is restrained, and at the same time, generation of the linear crystal defect (dislocation) which extends in the direction of a crystal growth from this well layer is restrained.

By applying the structure of the GaN-based III-V group compound semiconductor light-emitting element according to the present invention, generation of the planar and linear crystal defects can be restrained to obtain the GaN-based III-V group compound semiconductor light-emitting element having the light-emitting wavelength of 440 nm or more and having high light-emitting efficiency and high reliability.

### BRIEF DESCRIPTION OF THE DRAWINGS

FIG. 1 is a cross-sectiorial view showing a structure of a semiconductor laser element according to an embodiment of the present invention;
FIG. 2 is a layer-construction view showing an exemplary structure of an active layer representing background art that is useful for understanding the present invention;
FIG. 3 is a view showing band gap energy of each layer constituting the active layer of Fig. 2;
FIGS. 4A and 4B are cross-sectional views respectively showing main processes when manufacturing a semiconductor laser element which represents background art that is useful for understanding the present invention;
FIG. 5 is a layer-construction view showing an active layer structure of a light-emitting element according to the present invention;
FIG. 6 is a view showing band gap energy of each layer constituting an active layer as shown in Fig. 5;
FIG. 7 is a view showing band gap energy of each layer constituting an active layer of a light-emitting element according to the present invention;
FIG. 8 is a view showing band gap energy of each layer constituting an active layer of a light-emitting element according to the present invention;
FIG. 9 is a cross-sectional view showing an active layer structure of a sample of an experiment 1;
FIG. 10 is a cross-sectional view showing an active layer structure of a sample of an experiment 2; and
FIG. 11 is a cross-sectional view showing an active layer structure of a light-emitting element according to the present invention of samples of experiments 3 to 5.

### BEST MODE FOR CARRYING OUT THE INVENTION

Hereinafter, an embodiment of the present invention is specifically described in detail by referring to the attached drawings. It should be noted that a kind of a semiconductor light-emitting element, a film forming method, composition, a film thickness, a processing condition and the like of a compound semiconductor layer, which are shown in the following practice examples, are only examples in order to facilitate understanding of the present invention and therefore, the present invention is not limited to those examples.

### [Practice Example 1]

### (Practice Example of GaN-based III-V Group Compound Semiconductor Light-emitting Element which represents background art that is useful for understanding the present invention)

In this practice example, the GaN-based III-V group compound semiconductor light-emitting element according to the present invention is applied to a semiconductor laser element.

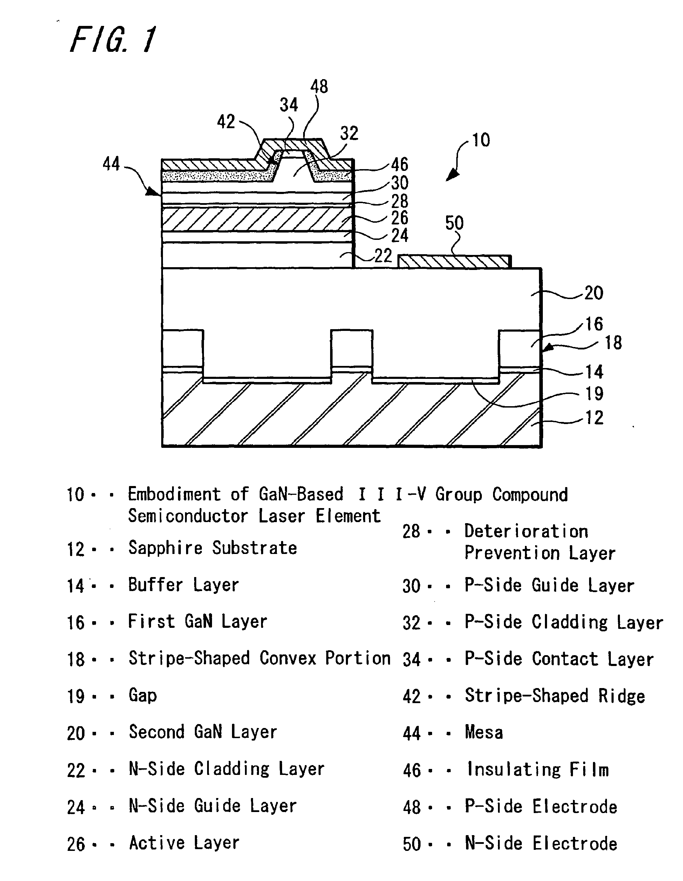

FIG. 1 is a cross-sectional view showing a structure of the semiconductor laser element according to this practice example;

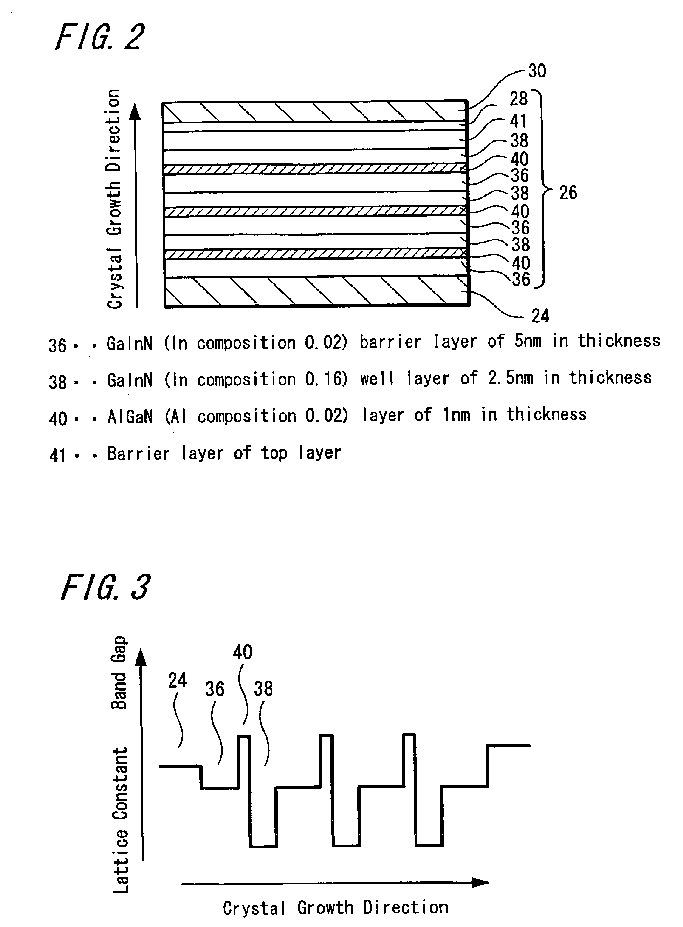

FIG. 2 is a layer-construction view showing a structure of an active layer; and FIG. 3 is a view showing band gap energy of each layer constituting an active layer.

A GaN-based III-V group compound semiconductor laser element (hereinafter, referred to as a semiconductor laser element) 10 according to this practice example is, as shown in FIG. 1, a semiconductor laser element having an oscillation wavelength of 450 nm, in which a first GaN layer 16 having a thickness of 1 µm is laminated on a C-plane of a sapphire substrate 12 through a buffer layer 14 made of a GaN-based semiconductor having a film thickness of 30 nm in a laminating direction (hereinafter, simply referred to as a film thickness), and a surface layer of the sapphire substrate 12, the buffer layer 14 and the first GaN layer 16 are etched to be a stripe shape and so a remaining portion is formed as a stripe-shaped convex portion 18.

The semiconductor laser element 10 has a second GaN layer 20 laminated on the substrate 12 including the stripe-shaped convex portion 18 by an ELO (Epitaxial Lateral Overgrowth) method and subsequently, on the second GaN layer 20 is provided a laminated-layer structure of an n-side cladding layer 22, an n-side guide layer 24, an active layer 26, a deterioration prevention layer 28, a p-side guide layer 30, a p-side cladding layer 32 and a p-side contact layer 34. In FIG. 1, a reference numeral 19 denotes a gap generated between the substrate 12 and the second GaN layer 20 when the second GaN layer 20 is laterally grown on the substrate 12.

The buffer layer 14 and the first GaN layer 16 are undoped layers, the second GaN layer 20 and the n-side guide layer 24 are formed of n-type GaN to which silicon (Si) is added as an n-type impurity, and the n-side cladding layer 22 is formed of an n-type AlGaN mixed crystal (where A1 composition is 0.07) layer to which Si is added as the n-type impurity.

As shown in FIG. 2, the active layer 26 has a quantum well structure including a barrier layer 36 made of a GaInN layer having a thickness of 5 nm and a well layer 38 made of a GaInN layer having a thickness of 2.5 nm, and has a structure in which a combination of a planar crystal defect prevention layer 40 made of an AlGaN layer having a thickness of 1 nm provided between the upper surface of the barrier layer 36 and the lower surface of the well layer 38 is laminated once to several times and the top layer is terminated with a barrier layer 41 (a triple quantum well structure in this practice example). The barrier layer 41 of the top layer has the same composition as the barrier layer 36 of a lower portion and has the same film thickness as the barrier layer 36 of the lower portion or is thicker than that.

For example, in a semiconductor laser having a light-emitting wavelength of 450 nm, when GaInN is selected as the barrier layer 36, In composition of the GaInN layer of the barrier layer 36 is made to be 0.02, In composition of the well layer 38 is made to be 0.16 and A1 composition of the planar crystal defect prevention layer 40 is made to be 0.02. In addition, a GaN layer may be provided as the barrier layer 36. In this case also, the In composition of the well layer 38 may be 0.16 and the Al composition of the planar crystal defect prevention layer 40 may be 0.02.

With this structure, each layer constituting the active layer 26 shows band gap energy as shown in FIG. 3.

The deterioration prevention layer 28 is formed of an AlGaN (Al composition 0.2) layer having a thickness of 20 nm, for example. The p-side guide layer 30 and the p-side contact layer 34 are formed of p-type GaN to which magnesium (Mg) is added as a p-type impurity. The p-side cladding layer 32 is formed of a p-type AlGaN mixed crystal (Al composition 0.07) layer to which Mg is added as the p-type impurity.

Upper portions of the p-side contact layer 34 and the p-side cladding layer 32 are formed as a stripe-shaped ridge 42 which functions as a current constriction structure.

Further, a lower portion of the p-side cladding layer 32, the p-side guide layer 30, the deterioration prevention layer 28, the active layer 26, the n-side guide layer 24 and the n-side cladding layer 22 are etched to be formed as a mesa 44 which is parallel to the ridge 42 and a part of the second GaN layer 20 is exposed at the side of the mesa 44.

An insulating film 46 made of an insulating material such as silicon dioxide (SiO₂) is formed on a lateral plane of the ridge 42 and on the p-side cladding layer 32 on the side of the ridge, and a p-side electrode 48 is formed to make an ohmic contact with the p-side contact layer 34 through a stripe-shaped opening on the ridge 42 of the insulating film 46. The p-side electrode 48 is made of a metal-laminated film in which palladium (Pd), Platinum (Pt) and Gold (Au) are laminated in order from the upper surface of the p-side contact layer 34. In addition, this p-side electrode 48 is formed in a narrow strip shape (in FIG. 1, a strip shape or a stripe shape extended in a vertical direction to the drawing) for the purpose of a current constriction.

Further, on the second GaN layer 20 exposed at the side of the mesa 44 is provided an n-side electrode 50 made of a metal-laminated film in which titanium (Ti), aluminum (Al) and gold (Au) are laminated in order.

In the semiconductor laser element 10 according to this practice example, although not illustrated, reflector layers are respectively provided on a pair of edge planes perpendicular to a longitudinal direction of the p-side electrode 48 (in other words, in the resonator length direction) to constitute a resonator structure.

In the semiconductor laser element 10 according to this practice example, since the planar crystal defect prevention layer 40 made of the AlGaN layer having a thickness of 1 nm is provided between the upper surface of the barrier layer 36 and the lower surface of the well layer 38 which constitute the active layer 26, a planar crystal defect and a linear crystal defect have not been generated even if the In composition of the well layer 38 is 0.16, which shows high In composition.

Accordingly, by employing the semiconductor laser element 10 according to this practice example, a semiconductor laser element which emits laser light having a wavelength of 440 nm or more with high output power, in high light-emitting efficiency and with high reliability can be obtained.

### [Practice Example 2]

### (Practice Example of Method for Manufacturing GaN-based III-V Group Compound Semiconductor Light-emitting Element which represents background art that is useful for understanding the present invention)

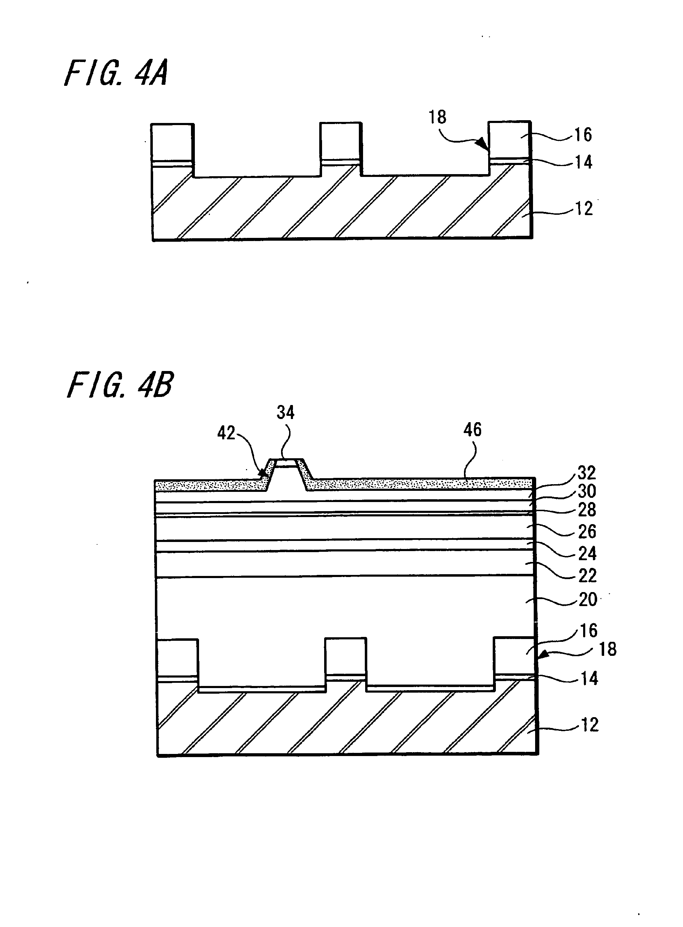

This practice example is an example in which a method for manufacturing a GaN-based III-V group compound semiconductor light-emitting element is applied to the manufacture of the semiconductor laser element 10 described in the above practice example. FIGS. 4A and 4B are cross-sectional views respectively showing main processes when a semiconductor laser element is manufactured in accordance with the method of this practice example.

In the manufacturing method according to this practice example, first, as shown in FIG. 4A, basically similarly to a method in the past, the undoped GaN buffer layer 14 is grown by a MOCDV method at a temperature of approximately 520°C on the C-plane of the sapphire substrate 12 whose surface is cleaned up beforehand by using a thermal cleaning or the like. Then, an undoped first GaN layer 16 is grown on the GaN buffer layer 14 at a growth temperature of approximately 1,000°C by the MOCVD method.

Subsequently, the substrate is taken out from a MOCVD apparatus; a protective mask made of a stripe-shaped SiO₂ film (not illustrated) which extends in a fixed direction is formed on the first GaN layer 16; and a surface layer of the first GaN layer 16, of the GaN buffer layer 14 and of the sapphire substrate 12 in a region exposed from the protective mask are etched by RIE to form the stripe-shaped convex portion 18.

The substrate is again installed in the MOCVD apparatus; the n-type second GaN layer 20 is epitaxially grown on the condition in which growth in a lateral direction occurs; and subsequently, on the second GaN layer 20 are sequentially formed by the MOCVD method the n-side AlGaN cladding layer 22, the n-side GaN optical guide layer 24, the active layer 26, the deterioration prevention layer 28, the p-side GaN optical guide layer 30, the p-side AlGaN cladding layer 32 and the p-side GaN contact layer 34 to form a laminated-layer structure as shown in FIG. 4B.

According to this practice example, when the active layer 26 is formed, the GaInN (where In composition is 0.02) layer having the thickness of 5 nm as the barrier layer 36, the AlGaN (where Al composition is 0.02) layer having the thickness of 1 nm as the planar crystal defect prevention layer 40 and the GaInN (where In composition is 0.16) layer having the thickness of 2.5 nm as the well layer 38 are sequentially formed; and a combination of the barrier layer 36, the planar crystal defect prevention layer 40 and the well layer 38 is laminated a predetermined number of times (three times in this practice example) and a top layer is terminated by the barrier layer 41.

With respect to growth materials of the above described GaN-based semiconductor layer, for example, trimethyl gallium ((CH₃)₃Ga, TMG) is used as raw materials of Ga of a III group element, trimethyl aluminum ((CH₃)₃Al, TMA1) is used as raw materials of Al of the III group element, trimethyl indium ((CH₃)₃In, TMIn) is used as raw materials of In of the III group element, and ammonia (NH₃) is used as raw materials of N of a V group element.

Further, a mixed gas of, for example, hydrogen (H₂) and nitrogen (N₂) is used as a carrier gas.

With respect to a dopant, monosilane (SiH₄), for example, is used as an n-type dopant, and as a p-type dopant, bis=methylcyclopentadienylmagnesium ((CH₃C₅H₄)₂Mg;MeCp₂Mg) or bis=cyclopentadienylmagnesium ((C₅H₅)₂MG;Cp₂Mg) is used, for example.

Next, the substrate on which the laminated-layer structure is formed is again taken out from the MOCVD apparatus, and upper portions of the p-side GaN contact layer 34 and the p-side cladding layer 32 are etched by photolithographing and a etching process, and so, as shown in FIG. 4B, the stripe-shaped ridge 42 is formed in a region between the adjacent convex portions 18 and the p-side cladding layer 32 is exposed at the side of a ridge.

Subsequently, the insulating film 46 made of SiO₂ is formed by, for example, a CVD method consecutively on the p-side GaN contact layer 34 of the ridge 42, on the lateral plane of the ridge 42 and on the p-side cladding layer 32.

Then, the insulating film 46 is coated with a resist film not shown in the drawing; a mask pattern, corresponding to a position where the p-side electrode 48 is formed, is formed by the photolithography processing; and after that, the insulating film 46 is selectively etched using the resist film as a mask to form, as shown in FIG. 4B, an opening which corresponds to the position where the p-side electrode 48 is formed.

Then, although not illustrated, palladium (Pd), platinum (Pt) and gold (Au), for example, are sequentially deposited on the whole substrate, that is, on the p-side GaN contact layer 34 from which the insulating film 46 is selectively removed and on the resist film not illustrated, and after that, both the resist film not illustrated and the laminated film of palladium, platinum and gold deposited on the resist film are removed by a lift-off method to form the p-side electrode 48 as shown in FIG. 1.

After forming the p-side electrode 48, correspondingly to a position where the n-side electrode 50 is formed, the insulating film 46, the p-side cladding layer 32, the p-side optical guide layer 30, the deterioration prevention layer 28, the active layer 26, the n-side optical guide layer 24 and the n-side cladding layer 22 are selectively removed in order, and so the mesa 44 is formed and the second GaN layer 20 is exposed.

Then, titanium, aluminum and gold are selectively deposited in order on the second GaN layer 20 to form the n-side electrode 50.

After forming the n-side electrode 50, the substrate 12 is cut open with a predetermined width perpendicularly to a longitudinal direction (a resonator length direction) of the p-side electrode 48 to form a reflector layer on the cut-off surface. Accordingly, the semiconductor laser element shown in FIG. 1 is formed.

In the above described practice examples, although only the MOCVD method is explained as the growth method, the growth may be attained using other vapor-phase growth method such as a halide vapor-phase growth method or a molecular beam epitaxy (MBE) method.

Further, in the above-described practice example, although only the case in which ELO method is used to restrain the generation of crystal defects due to lattice mismatch between the sapphire substrate and the GaN-based semiconductor is explained, a GaN substrate of low defect density can also be used.

In the GaN-based semiconductor laser element 10 manufactured as described above, since the planar crystal defect prevention layer 40 made of AlGaN is inserted between the upper surface of the barrier layer 36 and the lower surface of the well layer 38 in the active layer 26, generation of a planar crystal defect, which is generated due to an increase of In composition in the well layer 38, is restrained, and so the favorable crystalline well layer 38 can be formed. Moreover, since the planar crystal defect prevention layer 40 causing a large lattice mismatch with the well layer 38 is disposed only on the lower surface of the well layer 38, occurrence of dislocation which extends in the direction of a crystal growth from the well layer 38 can be restrained while maintaining a high device design margin.

Accordingly, in this practice example, since two kinds of crystal defects, namely the generation of planar and linear crystal defects which are generated due to an increase of In composition in a well layer can be restrained, a GaN-based semiconductor laser element which has high light-emitting efficiency and high reliability at a light-emitting wavelength of 440 nm or more can be manufactured.

### (Other Practice examples of GaN-based III-V Group Compound Semiconductor Light-emitting Element)

With respect to the GaN-based III-V group compound semiconductor light-emitting element according to the present invention, various other structures than the practice examples shown in FIGS. 1 to 3 can be provided. Other practice examples of the GaN-based III-V group compound semiconductor light-emitting element according to the present invention can be shown in the followings.

### [Practice Example 3]

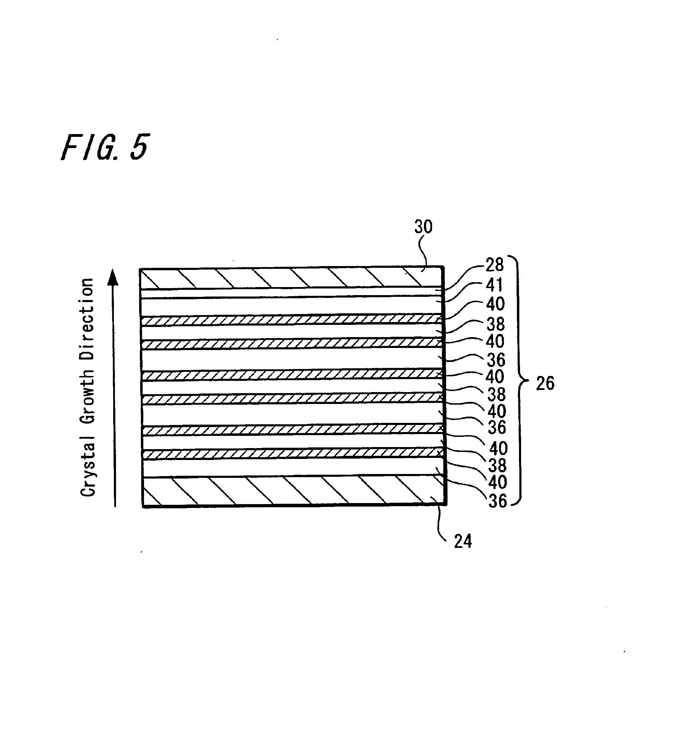

In this practice example, instead of the active layer of the practice example 1 shown in FIG. 2, the active layer shown in FIG. 5 is used to form the semiconductor laser element 10 shown in FIG. 1.

As shown in FIG. 5, the active layer 26 includes a barrier layer 36 made of GaInN layer having a thickness of 5 nm and a well layer 38 made of GaInN layer having a thickness of 2.5 nm constituting a quantum well structure, and has a structure in which a combination of a planar crystal defect prevention layer 40 made of an AlGaN layer having a thickness of 1 nm respectively provided between the upper surface of the barrier layer 36 and the lower surface of the well layer 38 and between the upper surface of the well layer 38 and the lower surface of the barrier layer 36 is laminated once to several times and the top layer is terminated with a barrier layer 41 (a triple quantum well structure in this example). The barrier layer 41 of the top layer has the same composition as the barrier layer 36 of a lower portion and has the same film thickness as the barrier layer 36 of the lower portion or is thicker than that.

For example, in a semiconductor laser having a light-emitting wavelength of 450 nm, when GaInN is selected as the barrier layer 36, In composition of the GaInN layer of the barrier layer 36 is made to be 0.02, In composition of the well layer 38 is made to be 0.16 and Al composition of the planar crystal defect prevention layer 40 is made to be 0.02. In addition, a GaN layer may be provided as the barrier layer 36. In this case also, the In composition of the well layer 38 may be 0.16 and the Al composition of the planar crystal defect prevention layer 40 may be 0.02.

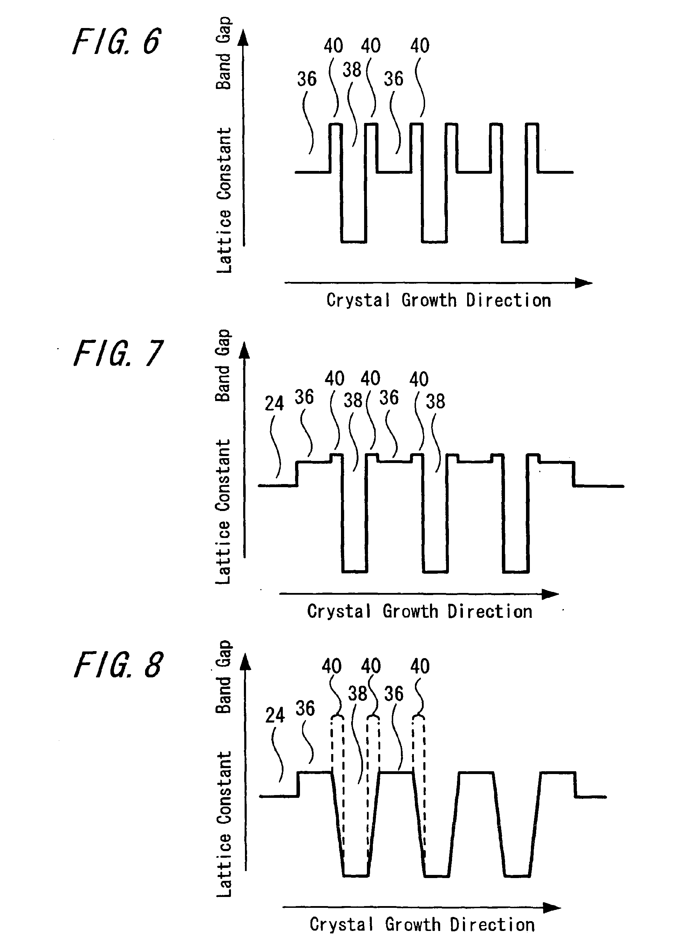

With this structure, each layer constituting the active layer 26 shows band gap energy as shown in FIG. 6.

### [Practice Example 4]

In this practice example, instead of the active layer of the practice example 1 shown in FIG. 2, the active layer shown in FIG. 5 is used to form the semiconductor laser element 10 shown in FIG. 1. Further, instead of GaInN of the practice example 3, AlGaN is used as the material of the barrier layer 36.

As shown in FIG. 5, the active layer 26 includes a barrier layer 36 made of AlGaN layer having a thickness of 5 nm and a well layer 38 made of GaInN layer having a thickness of 2.5 nm constituting a quantum well structure, and has a structure in which a combination of a planar crystal defect prevention layer 40 made of an AlGaN layer having a thickness of 0.5 nm respectively provided between the upper surface of the barrier layer 36 and the lower surface of the well layer 38 and between the upper surface of the well layer 38 and the lower surface of the barrier layer 36 is laminated once to several times and the top layer is terminated with a barrier layer 41 (a triple quantum well structure in this example). The barrier layer 41 of the top layer has the same composition as the barrier layer 36 of a lower portion and has the same film thickness as the barrier layer 36 of the lower portion or is thicker than that.

In addition, a GaN layer may be provided as the barrier layer 36.

With this structure, each layer constituting the active layer 26 shows band gap energy as shown in FIG. 7. In FIG. 7, the difference between the band gaps of the barrier layer 36 and the planar crystal defect prevention layer 40 becomes small.

### [Practice Example 5]

In this practice example, instead of the active layer of the practice example 1 shown in FIG. 2, the active layer shown in FIG. 5 is used to form the semiconductor laser element 10 shown in FIG. 1. Further, similarly to the practice example 4, AlGaN is used as the material of the barrier layer 36. Further, the planar crystal defect prevention layer 40 has a linearly-distributed composition gradient structure.

As shown in FIG. 5, the active layer 26 includes a barrier layer 36 made of AlGaN layer having a thickness of 5 nm and a well layer 38 made of GaInN layer having a thickness of 2.5 nm constituting a quantum well structure, and has a structure in which a combination of a planar crystal defect prevention layer 40 made of an AlInGaN layer having a thickness of 0.5 nm respectively provided between the upper surface of the barrier layer 36 and the lower surface of the well layer 38 and between the upper surface of the well layer 38 and the lower surface of the barrier layer' 36 is laminated once to several times and the top layer is terminated with a barrier layer 41 (a triple quantum well structure in this example). The barrier layer 41 of the top layer has the same composition as the barrier layer 36 of a lower portion and has the same film thickness as the barrier layer 36 of the lower portion or is thicker than that.

The planar crystal defect prevention layer 40 made of AlInGaN layer has a composition gradient structure distributed linearly from the same composition as the barrier layer to the same composition as the well layer 38.

For example, in a semiconductor laser having a light-emitting wavelength of 450 nm, when GaInN is selected as the barrier layer 36, In composition of the GaInN layer of the barrier layer 36 is made to be 0.02, In composition of the well layer 38 is made to be 0.16. Further, with respect to Al_{y1}In_{y2}Ga_{1-y1-y2}N layer of the planar crystal defect prevention layer 40, Al composition y1 is made to be 0.02 ≥ y1 ≥ 0 and In composition y2 is made to be 0 ≤ y2 ≤0.16. In addition, a GaN layer may be provided as the barrier layer 36.

With this structure, each layer constituting the active layer 26 shows band gap energy as shown in FIG. 8. In FIG. 8, since the planar crystal defect prevention layer 40 has the linearly-distributed composition gradient structure, the band gap thereof has an inclined surface.

### [Practice Example 6]

In this practice example, instead of the active layer of the practice example 1 shown in FIG. 2, the active layer shown in FIG. 5 is used to form the semiconductor laser element 10 shown in FIG. 1. Further, instead of GaInN of the practice example 3, AlInGaN is used as the material of the barrier layer 36.

As shown in FIG. 5, the active layer 26 includes a barrier layer 36 made of AlInGaN layer having a thickness of 5 nm and a well layer 38 made of GaInN layer having a thickness of 2.5 nm constituting a quantum well structure, and has a structure in which a combination of a planar crystal defect prevention layer 40 made of an AlInGaN layer having a thickness of 0.5 nm respectively provided between the upper surface of the barrier layer 36 and the lower surface of the well layer 38 and between the upper surface of the well layer 38 and the lower surface of the barrier layer 36 is laminated once to several times and the top layer is terminated with a barrier layer 41 (a triple quantum well structure in this example). The barrier layer 41 of the top layer has the same composition as the barrier layer 36 of a lower portion and has the same film thickness as the barrier layer 36 of the lower portion or is thicker than that. Further, the AlInGaN layer of the planar crystal defect prevention layer 40 is made to have more Al composition and less In composition in comparison with the AlInGaN of the barrier layer 36.

With this structure, similarly to the practice example 4, each layer constituting the active layer 26 shows band gap energy as shown in FIG. 7.

### [Practice Example 7]

In this practice example, instead of the active layer of the practice example 1 shown in FIG. 2, the active layer shown in FIG. 5 is used to form the semiconductor laser element 10 shown in FIG. 1. Further, similarly to the practice example 6, AlInGaN is used as the material of the barrier layer 36. Further, the planar crystal defect prevention layer 40 has a linearly-distributed composition gradient structure.

As shown in FIG. 5, the active layer 26 includes a barrier layer 36 made of AlInGaN layer having a thickness of 5 nm and a well layer 38 made of GaInN layer having a thickness of 2.5 nm constituting a quantum well structure, and has a structure in which a combination of a planar crystal defect prevention layer 40 made of an AlInGaN layer having a thickness of 0.5 nm respectively provided between the upper surface of the barrier layer 36 and the lower surface of the well layer 38 and between the upper surface of the well layer 38 and the lower surface of the barrier layer 36 is laminated once to several times and the top layer is terminated with a barrier layer 41 (a triple quantum well structure in this example). The barrier layer 41 of the top layer has the same composition as the barrier layer 36 of a lower portion and has the same film thickness as the barrier layer 36 of the lower portion or is thicker than that.

The planar crystal defect prevention layer 40 made of AlInGaN layer has the composition gradient structure distributed linearly from the same composition as the barrier layer to the same composition as the well layer 38.

With this structure, similarly to the practice example 5, each layer constituting the active layer 26 shows band gap energy as shown in FIG. 8.

Hence, in the case where the semiconductor laser 10 is formed with the active layer 26 having any structure among the above-described practice examples 3 to 7, if the well layer 38 has high In composition, planar crystal defects and linear crystal defects can be controlled not to be generated. Accordingly, a semiconductor laser element emitting laser light of 440 nm in wavelength with high output power, high light-emitting efficiency and high reliability can be obtained.

The present invention can provide a GaN-based III-V group compound semiconductor light-emitting element having high light-emitting efficiency and high reliability at a light-emitting wavelength of 440 nm or more, however, not limited thereto, and can be applied to the light-emitting element of any wavelength.

## Claims

1. A GaN-based III-V group compound semiconductor light-emitting element (10) having a light-emitting wavelength of 440nm or more and comprising an active layer (26) of a quantum well structure including
a barrier layer (36, 62) which has an upper surface and a further barrier layer (36, 62) which has a lower surface, wherein the barrier layer (36, 62) and the further barrier layer (36. 62) are made of a GaN-based compound semiconductor and
a well layer (38, 64) which has an upper surface and a lower surface and which is made of a GaInN layer,
wherein a planar crystal defect prevention layer (40, 72) made of an Alₓ₁Ga₁₋ₓ₁N layer (0.4 > x1 > 0.02) having a film thickness of 0.25 nm or more and 3 nm or less is provided between the upper surface of the barrier layer (36, 62) and the lower surface of the GaInN well layer (38, 64) and between the upper surface of the GaInN well layer (38, 64) and the lower surface of the further barrier layer (36, 62).

2. The GaN-based III-V group compound semiconductor light-emitting element according to claim 1,
wherein the well layer (38, 64) is a Ga_{1-z}In_{z}N (0<z<0.25) layer..

3. The GaN-based III-V group compound semiconductor light-emitting element according to claim 1 or 2,
wherein the barrier layer (36, 62) is a Ga₁₋ₓInₓN (0≤x<0.1) layer.

4. The GaN-based III-V group compound semiconductor light-emitting element according to claim 1 or 2,
wherein the barrier layer (36, 62) is a Al_{y}Ga_{1-y} N (0≤y<0.2) layer.

5. The GaN-based III-V group compound semiconductor light-emitting element according to claim 1 or 2,
wherein the barrier layer (36, 62) is Al_{z1}In_{z2}Ga_{1-z1-z2}N (where A1 composition z1 is 0≤z1<0.2, where In composition z2 is 0≤z2<0.1).

6. A method for manufacturing a GaN-based III-V group compound semiconductor light-emitting element (10) having a light-emitting wavelength of 440 nm or more and including an active layer (26) of a quantum well structure formed of
a barrier layer (36. 62) which has an upper surface and a further barrier layer (36, 62) which has a lower surface, wherein the barrier layer (36, 62) and the further barrier layer (36, 62) are made of a GaN-based compound semiconductor and of
a well layer (38, 64) which has an upper surface and a lower surface and which is made of a GaInN layer, the method comprising the step of:
providing a planar crystal defect prevention layer (40, 72) made of an Alₓ₁Ga₁₋ₓ₁N layer (0.4 > x1 > 0.02) having a film thickness of 0.25 nm or more and 3 nm or less between the upper surface of the barrier layer (36, 62) and the lower surface of the GaInN well layer (38, 64) and between the upper surface of the GaInN well layer (38, 64) and the lower surface of the further barrier layer (36, 62), when forming the active layer (26).

7. The method for manufacturing the GaN-based III-V group compound semiconductor light-emitting element according to claim 6,
wherein a Ga_{1-z}In_{z}N (where In composition z is 0<z<0.25) layer (38, 64) is formed as the well layer and a Ga₁₋ₓInₓN (0≤x<0.1) layer (36, 62) is formed as the barrier layer.

8. The method for manufacturing the GaN-based III-V group compound semiconductor light-emitting element according to claim 6,
wherein a Ga_{1-z}In_{z}N (where In composition z is 0<z<0.25) layer (38, 64) is formed as the well layer and a Al_{y}Ga_{1-y}N (where A1 composition y is 0≤y<0.2) layer (36, 62) is formed as the barrier layer.

9. The method for manufacturing the GaN-based III-V group compound semiconductor light-emitting element according to claim 6,
wherein a Ga_{1-z}In_{z}N (where In composition z is 0<z<0.25) layer (38, 64) is formed as the well layer and a Al_{z1}In_{z2}Ga_{1-z1-z2}N (where A1 composition z1 is 0≤z1<0.2, In composition z2 is 0≤z2<0.1) layer (36, 62) is formed as the barrier layer.

10. A GaN-based III-V group compound semiconductor light-emitting element (10) having a light-emitting wavelength of 440nm or more and comprising an active layer (26) of a quantum well structure including
a barrier layer (36, 62) which has an upper surface and a further barrier layer (36, 62) which has a lower surface, wherein the barrier layer (36, 62) and the further barrier layer (36, 62) are made of AlGaN layers, and
a well layer (38, 64) which has an upper surface and a lower surface and which is made of a GaInN layer,
wherein a planar crystal defect prevention layer (40, 72) made of an Alₓ₁Inₓ₂Ga₁₋ₓ₁₋ₓ₂N layer (0.4 > x1 > 0, 0<x2<xl) having a film thickness of 0.25 nm or more and 3 nm or less is provided between the upper surface of the Al_{z}Ga_{1-z}N barrier layer (36, 62) (where A1 composition z is 0.2 > z > 0) and the lower surface of the Ga_{1-y}In_{y}N well layer (38, 64) ) (where In composition y is 0.25 > y > 0) and between the upper surface of the Ga_{1-y}In_{y}N well layer (38, 64) ) (where In composition y is 0.25 > y > 0) and the lower surface of the further Al_{z}Ga_{1-z}N barrier layer (36, 62) (where Al composition z is 0.2 > z > 0).

11. A GaN-based III-V group compound semiconductor light-emitting element (10) having a light-emitting wavelength of 440 nm or more and comprising an active layer (26) of a quantum well structure including
a barrier layer (36, 62) which has an upper surface and a further barrier layer (36, 62) which has a lower surface, wherein the barrier layer (36, 62) and the further barrier layer (36, 62) are made of AlInGaN layers, and
a well layer (38, 64) which has an upper surface and a lower surface and which is made of a GaInN layer,
wherein a planar crystal defect prevention layer (40, 72) made of an Alₓ₁Ga₁₋ₓ₁₋ₓ₂ Inₓ₂N layer (0.4 > x1 > 0. 0<x2<x1) having a film thickness of 0.25 nm or more and 3 nm or less is provided between the upper surface of the Al_{z1}In_{z2}Ga_{1-z1-z2}N barrier layer (36, 62) (where Al composition z1 is 0.2 > z1 > 0 and In composition z2 is 0.1 > z2 > 0) and the lower surface of the Ga_{1-y}In_{y}N well layer (38, 64) ) (where In composition y is 0.25 > y > 0) and between the upper surface of the Ga_{1-y}In_{y}N well layer (38, 64) ) (where In composition y is 0.25 > y > 0) and the lower surface of the further Al_{z-1}In_{z2}Ga_{1-z1-z2}N barrier layer (36, 62) (where A1 composition z1 is 0.2 > z1 > 0 and In composition z2 is 0.1 > z2 > 0).

## Patentansprüche

1. GaN-basiertes Gruppe-III-V-Verbindungshalbleiterlichtemissionselement (10) mit einer Lichtemissionswellenlänge von 440 nm oder darüber und mit einer aktiven Schicht (26) einer Quantenwellstruktur,
mit
einer Barriereschicht (36, 62), welche eine obere Fläche aufweist, und einer weiteren Barriereschicht (36, 62), welche eine untere Fläche aufweist, wobei die Barriereschicht (36, 62) und die weitere Barriereschicht (36, 62) aus einem GaN-basierten Verbindungshalbleiter bestehen, und
einer Wellschicht (38, 64), die eine obere Fläche und eine untere Fläche aufweist und die aus einer GaInN-Schicht gebildet ist,
wobei eine planare Kristalldefektverhinderungsschicht (40, 72) aus einer Alₓ₁Ga₁₋ₓ₁N-Schicht (0,4 > x1 > 0,02) mit einer Schichtstärke von 0,25 nm oder mehr und 3 nm oder weniger zwischen der oberen Fläche der Barriereschicht (36, 62) und der unteren Fläche der GaInN-Wellschicht (38, 64) und zwischen der oberen Fläche der GaInN-Wellschicht (38, 64) und der unteren Fläche der weiteren Barriereschicht (36, 62) vorgesehen ist.

2. GaN-basiertes Gruppe-III-V-Verbindungshalbleiterlichtemissionselement nach Anspruch 1,
wobei die Wellschicht (38, 64) eine Ga_{1-z}In_{z}N-Schicht (0 < z <0,25) ist.

3. GaN-basiertes Gruppe-III-V-Verbindungshalbleiterlichtemissionselement nach Anspruch 1 oder 2,
wobei die Barriereschicht eine Ga₁₋ₓInₓN-Schicht (0 ≤ x < 0,1) ist.

4. GaN-basiertes Gruppe-III-V-Verbindungshalbleiterlichtemissionselement nach Anspruch 1 oder 2,
wobei die Barriereschicht (36, 62) eine Al_{y}Ga_{1-y}N-Schicht (0 ≤ y < 0,2) ist.

5. GaN-basiertes Gruppe-III-V-Verbindungshalbleiterlichtemissionselement nach Anspruch 1 oder 2,
wobei die Barriereschicht (36, 62) aus Al_{z1}In_{z2}Ga_{1-z1-z2}N besteht (wobei z1 der Anteil von A1 in der Zusammensetzung mit 0 ≤ z1 < 0,2 ist, wobei z2 der Anteil von In in der Zusammensetzung mit 0 ≤ z2 < 0,1 ist).

6. Verfahren zum Herstellen eines GaN-basierten Gruppe-III-V-Verbindungshalbleiterlichtemissionselements (10) mit einer Lichtemissionswellenlänge von 440 nm oder mehr und mit einer aktiven Schicht (26) einer Quantenwellstruktur,
gebildet durch
eine Barriereschicht (36, 62), welche eine obere Fläche aufweist, und eine weitere Barriereschicht (36, 62), welche eine untere Fläche aufweist, wobei die Barriereschicht (36, 62) und die weitere Barriereschicht (36, 62) aus einem GaN-basierten Verbindungshalbleiter bestehen, und
eine Wellschicht (38, 64), die eine obere Fläche und eine untere Fläche aufweist und die aus einer GaInN-Schicht gebildet ist,
wobei das Verfahren den Schritt aufweist:
Bereitstellen einer planaren Kristalldefektverhinderungsschicht (40, 72) aus einer Alₓ₁Ga₁₋ₓ₁N-Schicht (0,4 > x1 > 0,02) mit einer Schichtstärke von 0,25 nm oder mehr und 3 nm oder weniger zwischen der oberen Fläche der Barriereschicht (36, 62) und der unteren Fläche der GaInN-Wellschicht (38, 64) und zwischen der oberen Fläche der GaInN-Wellschicht (38, 64) und der unteren Fläche der weiteren Barriereschicht (36, 62), wenn die aktive Schicht (26) ausgebildet wird.

7. Verfahren zum Herstellen eines GaN-basierten Gruppe-III-V-Verbindungshalbleiterlichtemissionselements nach Anspruch 6,
wobei eine Ga_{1-z}In_{z}N-Schicht (38, 64) (wobei z den Anteil von In in der Zusammensetzung mit 0 < z < 0,25 ist) gebildet wird als die Wellschicht und eine Ga₁₋ₓInₓN-Schicht (36, 62) (0 ≤ x < 0,1) als die Barriereschicht ausgebildet ist.

8. Verfahren zum Herstellen eines GaN-basierten Gruppe-III-V-Verbindungshalbleiterlichtemissionselements nach Anspruch 6,
wobei eine Ga_{1-z}In_{z}N-Schicht (38, 64) (wobei z der Anteil von In in der Zusammensetzung mit 0 < z < 0,25 ist) gebildet wird als die Wellschicht und eine Al_{y}Ga_{1-y}N-Schicht (36, 62) (wobei y der Anteil von A1 in der Zusammensetzung mit 0 ≤ y < 0,2 ist) als die Barriereschicht ausgebildet wird.

9. Verfahren zum Herstellen eines GaN-basierten Gruppe-III-V-Verbindungshalbleiterlichtemissionselements nach Anspruch 6,
wobei eine Ga_{1-z}In_{z}N-Schicht (38, 64) (wobei z der Anteil von In in der Zusammensetzung mit 0 < z < 0,25 ist) ausgebildet wird als die Wellschicht und eine Al_{z1}In_{z2}Ga_{1-z1-z2}N-Schicht (36, 62) (wobei z1 der Anteil von A1 in der Zusammensetzung mit 0 ≤ z1 < 0,2 und z2 der Anteil von In in der Zusammensetzung mit 0 ≤ z2 < 0,1 ist) als die Barriereschicht ausgebildet wird.

10. GaN-basiertes Gruppe-III-V-Verbindungshalbleiterlichtemissionselement (10) mit einer Lichtemissionswellenlänge von 440 nm oder darüber und mit einer aktiven Schicht (26) einer Quantenwellstruktur,
mit
einer Barriereschicht (36, 62), welche eine obere Fläche aufweist, und einer weiteren Barriereschicht (36, 62), welche eine untere Fläche aufweist, wobei die Barriereschicht (36, 62) und die weitere Barriereschicht (36, 62) aus AIGaN-Schichten bestehen, und
einer Wellschicht (38, 64), die eine obere Fläche und eine untere Fläche aufweist und die aus einer GaInN-Schicht gebildet ist,
wobei eine planare Kristalldefektverhinderungsschicht (40, 72) aus einer Alₓ₁Inx₂Ga₁₋ₓ₁₋ₓ₂N-Schicht (0,4 > x1 > 0, 0 < x2 <xl) mit einer Schichtstärke von 0,25 nm oder mehr und 3 nm oder weniger vorgesehen ist zwischen der oberen Fläche der Al_{z}Ga_{1-z}N-Barriereschicht (36, 62) (wobei z der Anteil von A1 in der Zusammensetzung mit 0,2 > z > 0 ist) und der unteren Fläche der Ga_{1-y}In_{y}N-Wellschicht (36, 62) (wobei y der Anteil von In in der Zusammensetzung mit 0,25 > y > 0 ist) und zwischen der oberen Fläche der Ga_{1-y}In_{y}N-Wellschicht (38, 64) (wobei y der Anteil von In in der Zusammensetzung mit 0,25 > y > 0 ist) und der unteren Fläche der weiteren Al_{z}Ga_{1-z}N-Barriereschicht (36, 62) (wobei z der Anteil von A1 in der Zusammensetzung mit 0,2 > z > 0 ist).

11. GaN-basiertes Gruppe-III-V-Verbindungshalbleiterlichtemissionselement (10) mit einer Lichtemissionswellenlänge von 440 nm oder darüber und mit einer aktiven Schicht (26) einer Quantenwellstruktur,
mit
einer Barriereschicht (36, 62), welche eine obere Fläche aufweist, und einer weiteren Barriereschicht (36, 62), welche eine untere Fläche aufweist, wobei die Barriereschicht (36, 62) und die weitere Barriereschicht (36, 62) aus AlInGaN-Schichten bestehen, und
einer Wellschicht (38, 64), die eine obere Fläche und eine untere Fläche aufweist und die aus einer GaInN-Schicht gebildet ist,
wobei eine planare Kristalldefektverhinderungsschicht (40, 72) aus einer Alₓ₁Ga₁₋ₓ₁₋ₓ₂Inₓ₂N-Schicht (0,4 > x1 > 0, 0 < x2 <x1) mit einer Schichtstärke von 0,25 nm oder mehr und 3 nm oder weniger vorgesehen ist zwischen der oberen Fläche der Al_{z1}In_{z2}Ga_{1-z1-z2}N-Barriereschicht (36, 62) (wobei z1 der Anteil von A1 in der Zusammensetzung mit 0,2 > z1 > 0 und z2 der Anteil von In in der Zusammensetzung mit 0,1 > z2 > 0 ist) und der unteren Fläche der Ga_{1-y}In_{y}N-Wellschicht (38, 64) (wobei y der Anteil von In in der Zusammensetzung mit 0,25 > y >0 ist) und zwischen der oberen Fläche der Ga_{1-y}In_{y}N-Wellschicht (38, 64) (wobei y der Anteil von In in der Zusammensetzung mit 0,25 > y >0 ist) und der unteren Fläche der weiteren Al_{z1}In_{z2}Ga_{1-z1-z2}N-Barriereschicht (36, 62) (wobei z1 der Anteil von A1 in der Zusammensetzung mit 0,2 > z1 > 0 ist und z2 der Anteil von In in der Zusammensetzung mit 0,1 > z2 > 0 ist).

## Revendications

1. Elément électroluminescent (10) à semi-conducteurs composés du groupe III-V à base de GaN, ayant une longueur d'onde d'émission de lumière de 440 nm ou plus et comprenant une couche active (26) ayant une structure de puit quantique incluant :
une couche barrière (36, 62) qui a une surface supérieure, et une couche barrière supplémentaire (36, 62) qui a une surface inférieure, la couche barrière (36, 62) et la couche barrière supplémentaire (36, 62) étant constituées d'un semi-conducteur composé à base de GaN, et
une couche de puits (38, 64) qui a une surface supérieure et une surface inférieure et qui est constituée d'une couche de GaInN,
dans lequel une couche de prévention des défauts cristallins plans (40, 72) constituée d'une couche d'Alₓ₁Ga₁₋ₓ₁N (0,4 > x1 > 0,02) ayant une épaisseur de film de 0,25 nm ou plus et de 3 nm ou moins est prévue entre la surface supérieure de la couche barrière (36, 62) et la surface inférieure de la couche de puits en GaInN (38, 64) et entre la surface supérieure de la couche de puits de GaInN (38, 64) et la surface inférieure de la couche barrière supplémentaire (36, 62).

2. Elément électroluminescent à semi-conducteurs composés du groupe III-V à base de GaN selon la revendication 1,
dans lequel la couche de puits (38, 64) est une couche de Ga_{1-z}In_{z}N (0 < z < 0,25).

3. Elément électroluminescent à semi-conducteurs composés du groupe III-V à base de GaN selon la revendication 1 ou 2,
dans lequel la couche barrière (36, 62) est une couche de Ga₁₋ₓInₓN (0 ≤ x < 0,1).

4. Elément électroluminescent à semi-conducteurs composés du groupe III-V à base de GaN selon la revendication 1 ou 2,
dans lequel la couche barrière (36, 62) est une couche d'Al_{y}Ga_{1-y}N (0 ≤ y < 0,2).

5. Elément électroluminescent à semi-conducteurs composés du groupe III-V à base de GaN selon la revendication 1 ou 2,
dans lequel la couche barrière (36, 62) est une couche d'Al_{z1}In_{z2}Ga_{1-z1-z2}N (où la composition z1 en A1 est telle que 0 ≤ z1 < 0,2 et la composition z2 en In est telle que 0 ≤ z2 < 0,1).

6. Procédé de fabrication d'un élément électroluminescent (10) à semi-conducteurs composés du groupe III-V à base de GaN, ayant une longueur d'onde d'émission de lumière de 440 nm ou plus et comprenant une couche active (26) ayant une structure de puit quantique formée :
d'une couche barrière (36, 62) qui a une surface supérieure, et d'une couche barrière supplémentaire (36, 62) qui a une surface inférieure, la couche barrière (36, 62) et la couche barrière supplémentaire (36, 62) étant constituées d'un semi-conducteur composé à base de GaN, et
d'une une couche de puits (38, 64) qui a une surface supérieure et une surface inférieure et qui est constituée d'une couche de GaInN, le procédé comprenant l'étape qui consiste à :
prévoir une couche de prévention des défauts cristallins plans (40, 72) constituée d'une couche d'Alₓ₁Ga₁₋ₓ₁N (0,4 > x1 > 0,02) ayant une épaisseur de film de 0,25 nm ou plus et de 3 nm ou moins est prévue entre la surface supérieure de la couche barrière (36, 62) et la surface inférieure de la couche de puits en GaInN (38, 64) et entre la surface supérieure de la couche de puits de GaInN (38, 64) et la surface inférieure de la couche barrière supplémentaire (36, 62), lors de la formation de la couche active (26).

7. Procédé de fabrication de l'élément électroluminescent à semi-conducteurs composés du groupe III-V à base de GaN selon la revendication 6,
dans lequel une couche (38, 64) de Ga_{1-z}In_{z}N (où la composition z en In est telle que 0 < z < 0,25) est formée en tant que couche de puits et une couche (36, 62) de Ga₁₋ₓInₓN (0 ≤ x < 0,1) est formée en tant que couche barrière.

8. Procédé de fabrication de l'élément électroluminescent à semi-conducteurs composés du groupe III-V à base de GaN selon la revendication 6,
dans lequel une couche (38, 64) de Ga_{1-z}In_{z}N (où la composition z en In est telle que 0 < z < 0,25) est formée en tant que couche de puits et une couche (36, 62) d'Al_{y}Ga_{1-y}N (où la composition y en Al est telle que 0 ≤ y < 0,2) est formée en tant que couche barrière.

9. Procédé de fabrication de l'élément électroluminescent à semi-conducteurs composés du groupe III-V à base de GaN selon la revendication 6,
dans lequel une couche (38, 64) de Ga_{1-z}In_{z}N (où la composition z en In est telle que 0 < z < 0,25) est formée en tant que couche de puits et une couche (36, 62) d'Al_{z1}In_{z2}Ga_{1-z1-z2}N (où la composition z1 en Al est telle que 0 ≤ z1 < 0,2, et la composition z2 en In est telle que 0 ≤ z2 < 0,1) est formée en tant que couche barrière.

10. Elément électroluminescent (10) à semi-conducteurs composés du groupe III-V à base de GaN, ayant une longueur d'onde d'émission de lumière de 440 nm ou plus et comprenant une couche active (26) ayant une structure de puit quantique incluant :
une couche barrière (36, 62) qui a une surface supérieure, et une couche barrière supplémentaire (36, 62) qui a une surface inférieure, la couche barrière (36, 62) et la couche barrière supplémentaire (36, 62) étant constituées de couches d'AlGaN, et
une couche de puits (38, 64) qui a une surface supérieure et une surface inférieure et qui est constituée d'une couche de GaInN,
dans lequel une couche de prévention des défauts cristallins plans (40, 72) constituée d'une couche d'Alₓ₁Inₓ₂Ga₁₋ₓ₁₋ₓ₂N (0,4 > x1 > 0, 0 < x2 < x1) ayant une épaisseur de film de 0,25 nm ou plus et de 3 nm ou moins est prévue entre la surface supérieure de la couche barrière (36, 62) en Al_{z}Ga_{1-z}N (où la composition z en Al est telle que 0,2 > z > 0) et la surface inférieure de la couche de puits (38, 64) en Ga_{1-y}In_{y}N (où la composition y en In est telle que 0,25 > y > 0) et entre la surface supérieure de la couche de puits (38, 64) en Ga_{1-y}In_{y}N (où la composition y en In est telle que 0,25 > y > 0) et la surface inférieure de la couche barrière (36, 62) en Al_{z}Ga_{1-z}N (où la composition z en Al est telle que 0,2 > z > 0).

11. Elément électroluminescent (10) à semi-conducteurs composés du groupe III-V à base de GaN, ayant une longueur d'onde d'émission de lumière de 440 nm ou plus et comprenant une couche active (26) ayant une structure de puit quantique incluant :
une couche barrière (36, 62) qui a une surface supérieure, et une couche barrière supplémentaire (36, 62) qui a une surface inférieure, la couche barrière (36, 62) et la couche barrière supplémentaire (36, 62) étant constituées de couches d'AlInGaN, et
une couche de puits (38, 64) qui a une surface supérieure et une surface inférieure et qui est constituée d'une couche de GaInN,
dans lequel une couche de prévention des défauts cristallins plans (40, 72) constituée d'une couche d'Alₓ₁Ga₁₋ₓ₁₋ₓ₂Inₓ₂N (0,4 > x1 > 0, 0 < x2 < x1) ayant une épaisseur de film de 0,25 nm ou plus et de 3 nm ou moins est prévue entre la surface supérieure de la couche barrière (36, 62) en Al_{z1}In_{z2}Ga_{1-z1-z2}N (où la composition z1 en A1 est telle que 0,2 > z1 > 0, et la composition z2 en In est telle que 0,1 > z2 > 0) et la surface inférieure de la couche de puits (38, 64) en Ga_{1-y}In_{y}N (où la composition y en In est telle que 0,25 > y > 0) et entre la surface supérieure de la couche de puits (38, 64) en Ga_{1-y}In_{y}N (où la composition y en In est telle que 0,25 > y > 0) et la surface inférieure de la couche barrière (36, 62) en Al_{z1}In_{z2}Ga_{1-z1-z2}N (où la composition z1 en A1 est telle que 0,2 > z1 > 0, et la composition z2 en In est telle que 0,1 > z2 > 0).
